# EUROPEAN PATENT APPLICATION

(11) **EP 4 553 509 A1**
(43) Date of publication of application: **14.05.2025**
(21) Application number: 23859526.8
(22) Date of filing: 08.10.2023
(51) Int. Cl.: G01R 31/00, F16K 37/00

(54) **DEVICE FOR TESTING STEAM TURBINE VALVE CHARACTERISTICS**

(30) Priority: 02.09.2022 CN 202211071210
(71) Applicant: Suzhou Nuclear Power Research Institute Co., Ltd., Suzhou, Jiangsu 215004 (CN); China Nuclear Power Operations Co., Ltd., Shenzhen, Guangdong 518000 (CN); China General Nuclear Power Corporation, Shenzhen, Guangdong 518026 (CN); CGN Power Co., Ltd., Shenzen, Guangdong 518026 (CN)
(72) Inventor: MA, Lei, Suzhou, Jiangsu 215004 (CN); WANG, Zhaoming, Suzhou, Jiangsu 215004 (CN); CHE, Yinhui, Suzhou, Jiangsu 215004 (CN); HUANG, Xiangjun, Suzhou, Jiangsu 215004 (CN); FENG, Dehu, Suzhou, Jiangsu 215004 (CN)
(74) Representative: Westphal, Mussgnug & Partner, Patentanwälte mbB
(86) International application number: PCT/CN2023/123351
(87) International publication number: WO 2024/046500

(57) **Abstract**

A device for testing steam turbine valve characteristics, comprising a case, wherein a control card (1), an acquisition card (2) connected to the control card (1), an acquisition interface (3) connected to the acquisition card (2) and a pressure sensor in a hydraulic servomotor, and an industrial personal computer (4) connected to the control card (1) and the acquisition card (2) are provided in the case. According to the device, a worker can comprehensively and intuitively monitor the operation of a proportional valve and perform fault diagnosis, so that a fault can be predicted in advance, and a fault handling person is prompted to take a corresponding measure, and during maintenance of a control system for a steam turbine valve, the control system can be replaced with the device to control the proportional valve, so that the reliability of a steam turbine valve system is improved.

## Description

### TECHNICAL FIELD

The invention relates to the technical field of equipment maintenance, in particular to a device for testing steam turbine valve characteristics.

### DESCRIPTION OF RELATED ART

In the related technology, the steam turbine of a nuclear power plant is controlled by the proportional control valve (referred to as proportional valve), when the pilot valve jamming, the main valve jamming, the control card failure, the signal transmission failure and other faults occur, the proportional valve may be closed and opened instantaneously. Therefore, in order to maintain the stable operation of the nuclear power plant, it is necessary to monitor and test the operation of the proportional valve regularly. At present, although the existing steam turbine valve system will also monitor some data of the proportional valve, the fault diagnosis means are limited, which making it difficult to effectively determine the cause of the fault, and cannot predict the fault in advance.

### BRIEF SUMMARY OF THE INVENTION

The technical problem to be solved by the invention is to provide a device for testing steam turbine valve characteristics for at least one defect existing in the prior art.

The technical scheme adopted by the invention for solving the technical problems is as follows: the device for testing steam turbine valve characteristics comprises a case, wherein a control card, an acquisition card, an acquisition interface and an industrial personal computer are arranged in the case.

The control card is used for controlling a proportional valve to work.

The acquisition card is connected to the control card and is used for acquiring a feedback signal and a control signal of the control card. Wherein the feedback signal comprises at least one of a pilot valve feedback signal, a main valve feedback signal and a hydraulic servomotor feedback signal, and the control signal comprises at least one of a coil current signal, a zero-point instruction signal, a condition instruction signal, a PID control signal and an integrator output signal.

The acquisition interface is connected to the acquisition card and also connected to a pressure sensor in the hydraulic servomotor so as to send an oil pressure signal to the acquisition card.

And the industrial personal computer is connected to the control card and the acquisition card, and is used for controlling the control card to work and processing the feedback signal, the control signal and the oil pressure signal to generate a corresponding characteristic curve.

Preferably, the case is a clamshell case, and an operation panel for controlling the industrial personal computer is further arranged in the clamshell case.

And the operation panel is provide with a selection switch unit which is used for control the on-off of the feedback signal, realizing the enabling function and setting the work mode.

Preferably, the device further comprises a touch screen arranged on the inner side of the flip of the clamshell case, wherein the touch screen is connected to the industrial personal computer, and the touch screen is used for displaying the characteristic curves of the feedback signal, the control signal and the oil pressure signal in real time and acquiring a control instruction.

Preferably, the control card comprises a zero-point instruction signal processing unit; Which comprises a resistor R124, a resistor R123, an operational amplifier N10B, a resistor R126, a resistor R125, a resistor R122, a zener diode D15, a resistor R77, an inverter N6E, a diode T19A, an operational amplifier N10A, a resistor R111, a resistor R112, a resistor R110, a diode T19B, a resistor R78, an inverter N6D, a resistor R76, an NPN transistor T20, a resistor R75, a PNP transistor T17, a resistor R84, a diode D14, a resistor R85, a zener diode D52 and a resistor R7.

The second end of the resistor R124 is used for receiving a zero-point control signal, the second end of the resistor R124 is further connected to the non-inverting input end of the operational amplifier N10B via the resistor R123, and the inverting input end of the operational amplifier N10B is connected to the ground via the resistor R126. The inverting input end of the operational amplifier N10B is also connected to the positive end of a first DC voltage via the resistor R125, the output end of the operational amplifier N10B is connected to the non-inverting input end of the operational amplifier N10B via the resistor R122, and the output end of the operational amplifier N10B is also connected to the anode of the zener diode D15; The cathode of the zener diode D15 is connected to a second DC voltage via the resistor R77, the cathode of the zener diode D15 is also connected to the input end of the inverter N6E, and the output end of the inverter N6E is connected to the anode of the diode T19A;

The first end of the resistor R124 is connected to the non-inverting input end of the operational amplifier N10A, the inverting input end of the operational amplifier N10A is connected to the negative end of the first DC voltage via the resistor R111, and the inverting input end of the operational amplifier N10A is connected to the ground via the resistor R112; The non-inverting input end of the operational amplifier N1A is connected to the output end of the operational amplifier N10A via the resistor R110, and the output end of the operational amplifier N10A is connected to the anode of the diode T19B.

The cathode of the diode T19A is connected to the cathode of the diode T19B, the cathode of the diode T19B is connected to the ground via the resistor R78, the cathode of the diode T19B is further connected to the input end of the inverter N6D, the output end of the inverter N6D is connected to the base of the NPN transistor T20 via the resistor R76, the emitter of the PNP transistor T20 is grounded, the collector of the PNP transistor T20 is connected to the base of the PNP transistor T17 via the resistor R75, the base of the PNP transistor T17 is connected to a third DC voltage via the resistor R84, and the collector of the PNP transistor T17 is connected to the ground via the resistor R85; the collector of the PNP transistor T17 is further connected to the anode of the diode D14, the cathode of the diode D14 and the emitter of the PNP transistor T17 are connected to a third DC voltage, the anode of the diode D14 is further connected to the cathode of the zener diode D52, and the anode of the zener diode D52 is grounded; The anode of the diode D14 is further connected to the first end of the resistor R7, the second end of the resistor R7 is connected to the acquisition card as a zero-point instruction signal output end, and the zero-point instruction signal output end is used to connect the proportional valve.

Preferably, the control card further comprises a condition instruction signal setting unit, which comprises a diode D18, a resistor R96, a zener diode D4, an adjustable resistor P3, a resistor R14, a resistor R113, a diode D2, a resistor R12, an adjustable resistor P2, a zener diode D3, a resistor R13, a resistor R114, a zener diode D20, a zener diode D19, a resistor R121, a resistor R15, an adjustable resistor P1, a resistor R117, an operational amplifier N10C, a resistor R120, a resistor R196 and a protection tube D43.

The anode of the diode D18 is connected to the output end of the operational amplifier N10A, the cathode of the diode D18 is connected to the cathode of the zener diode D4 via the resistor R96, the anode of the zener diode D4 is grounded, and the cathode of the zener diode D4 is also connected to the second end of the adjustable resistor P3; The first end of the adjustable resistor P3 is connected to the ground via the resistor R14, and the adjustable end of the adjustable resistor P3 is connected to the first end of the resistor R113.

The cathode of the diode D2 is connected to the output end of the operational amplifier N10B, the anode of the diode D2 is connected to the second end of the adjustable resistor P2 via the resistor R12, the second end of the adjustable resistor P2 is connected to the anode of the zener diode D3, and the cathode of the zener diode D3 is grounded; The first end of the adjustable resistor P2 is connected to the ground via the resistor R13, and the adjustable end of the adjustable resistor P2 is connected to the first end of the resistor R114.

The second end of the resistor R114 is connected to the second end of the resistor R113 and the anode of the zener diode D20, the cathode of the zener diode D20 is connected to the cathode of the zener diode D19, and the second end of the resistor R114 is connected to the anode of the zener diode D19 and the output end of the operational amplifier N10C via the resistor R121. The second end of the resistor R114 is connected to the adjustable end of the adjustable resistor P1 via the resistor R15, the first end of the adjustable resistor P1 is connected to the positive end of a first DC voltage, and the second end of the resistor R114 is further connected to the second end of the resistor R117 and the inverting input end of the operational amplifier N10C; The first end of the resistor R117 is connected to the industrial personal computer, the non-inverting input end of the operational amplifier N10C is connected to the ground via the resistor 120, the output end of the operational amplifier N10C is connected to the first end of the resistor R196, and the second end of the resistor R196 is connected to the ground via the protection tube D43. The second end of the resistor R196 is connected to the acquisition card as a conditional instruction signal output end.

Preferably, the control card further comprises a coil current signal processing unit; Which comprises a switching control unit, a resistor R162, an NPN transistor T6, a resistor R161, a resistor R154, a resistor R164, a PNP transistor T8, an NPN transistor T9, a resistor R205, a zener diode D28, a PMOS transistor T2, an inductor L4, a diode D34, a capacitor C5, a resistor R173, an operational amplifier N16A, a resistor R183, a resistor R172, a resistor R181, a resistor R188, a NMOS transistor T3, a resistor R163, a resistor R174, a diode D35 and an inductor L3;

The switching signal output end of the switching control unit is connected to the base of the NPN transistor T6 via the resistor R162, the base of the NPN transistor T6 is also connected to the ground via the resistor R161, the emitter of the NPN transistor T6 is connected to the ground via the resistor R154, The collector of the NPN transistor T6 is connected to a third DC voltage via the resistor R164, the collector of the NPN transistor T6 is also connected to the base of the PNP transistor T8 and the base of the NPN transistor T9, the collector of the NPN transistor T9 is connected to the third DC voltage, and the emitter of the NPN transistor T9 is connected to the emitter of the PNP transistor T8; The collector of the PNP transistor T8 is grounded, the emitter of the PNP transistor T8 is also connected to the anode of the zener diode D28 via the resistor R205, the anode of the zener diode D28 is connected to the gate of the PMOS transistor T2, and the cathode of the zener diode D28 and the source of the PMOS transistor T2 are connected to the third DC voltage; The drain of the PMOS transistor T2 is connected to the first end of the inductor L4 and the cathode of the diode D34, the second end of the inductor L4 is connected to the ground via the capacitor C5, and the second end of the inductor L4 is a first coil current signal output end that can be connected to the electromagnet coil of the pilot valve.

The anode of the diode D34 is connected to the inverting input end of the operational amplifier N16A via the resistor R173, the anode of the diode D34 is also connected to ground via the resistor R183, the inverting input end of the operational amplifier N16A is connected to the output end of the operational amplifier N16A via the resistor R172; The output end of the operational amplifier N16A is connected to the acquisition card as an error signal sampling end, the non-inverting input end of the operational amplifier N16A is connected to the ground via the resistor R181, and the non-inverting input end of the operational amplifier N16A is also connected to the source of the NMOS transistor T3 via the resistor R188; The source of the NMOS transistor T3 is connected to the ground via the resistor R174, the gate of the NMOS transistor T3 is connected to the switching signal output end of the switching control unit via the resistor R163, the drain of the NMOS transistor T3 is connected to the anode of the diode D35, and the cathode of the diode D35 is connected to the third DC voltage. The drain of the NMOS transistor T3 is also connected to the first end of the inductor L3, and the second end of the inductor L3 is a second coil current signal output end which can be connected to the electromagnet coil of the pilot valve.

Preferably, the control card further comprises a hydraulic servomotor feedback signal processing unit and an integrator output signal processing unit;

The hydraulic servomotor feedback signal processing unit is configured to acquire voltage and current signals fed back by the proportional valve, and process the voltage and current signals to obtain current and voltage feedback signals;

The integrator output signal processing unit comprises an adjustable resistor P4, a resistor R25, a resistor R23, an operational amplifier N3A, a resistor R1, a resistor R40, a zener diode D2, a zener diode D1, a capacitor C6, a selection switch K2F, a diode D3 and a resistor R10.

The first end of the adjustable resistor P4 is connected to the hydraulic servomotor feedback signal processing unit to receive the current and voltage feedback signals, the second end of the adjustable resistor P4 is connected to the ground via the resistor R25, and the adjustable end of the adjustable resistor P4 is connected to the inverting input end of the operational amplifier N3A via the resistor R23; The inverting input end of the operational amplifier N3A is connected to the second end of the resistor R1, the second end of the resistor R1 is connected to the enabling unit of the control card, the non-inverting input end of the operational amplifier N3A is connected to the ground via the resistor R40, and the inverting input end of the operational amplifier N3A is also connected to the anode of the zener diode D2; The cathode of the zener diode D2 is connected to the cathode of the zener diode D1, the anode of the zener diode D1 is connected to the output end of the operational amplifier N3A, the anode of the zener diode D1 is connected to the enabling unit, the inverting input end of the operational amplifier N3A is connected to the output end of the operational amplifier N3A via the capacitor C6, the inverting input end of the operational amplifier N3A is also connected to the anode of the diode D3 via the selection switch K2F, the cathode of the diode D3 is connected to the output end of the operational amplifier N3A, the output end of the operational amplifier N3A is connected to the first end of the resistor R10, the second end of the resistor R10 is connected to the acquisition card as an integrator output signal output end.

Preferably, the control card further comprises a hydraulic servomotor feedback signal acquisition unit and/or a controller output signal processing unit;

The hydraulic servomotor feedback signal acquisition unit is connected to the hydraulic servomotor feedback signal processing unit and the acquisition card to filter the current and voltage feedback signals and send the filtered signals to the acquisition card.

The controller output signal processing unit is connected to the integrator output signal processing unit and the hydraulic servomotor feedback signal processing unit to perform operation according to the integrator output signal output by the integrator output signal processing unit, and the current and voltage feedback signals to obtain the PID control output signal; And send the PID control output signal to the acquisition card.

Preferably, the control card further comprises two valve feedback signal processing units.

The input end of one valve feedback signal processing unit is connected to the acquisition card and can be connected to the pilot valve feedback signal output end of the proportional valve, and the output end of that valve feedback signal processing unit is connected to the industrial personal computer.

The input end of the other valve feedback signal processing unit is connected to the acquisition card and can be connected to the main valve feedback signal output end of the proportional valve, and the output end of that valve feedback signal processing unit is connected to the industrial personal computer.

Preferably, each valve feedback signal processing unit comprises a zener diode D51, a resistor R74, an operational amplifier N3A, a resistor R83, a resistor R41, a resistor R27, a resistor R28, an adjustable resistor P8, a resistor R26, an operational amplifier N3B, a resistor R58, a resistor R25 and a protection tube D42.

The cathode of the zener diode D51 is the input end of the valve feedback signal processing unit, the cathode of the zener diode D51 is connected to the inverting input end of the operational amplifier N3A via the resistor R74, the cathode of the zener diode D51 is also connected to the ground via the resistor R83, and the anode of the zener diode D51 is grounded; The inverting input end of the operational amplifier N3A is connected to the output end of the operational amplifier N3A via the resistor R41, the non-inverting input end of the operational amplifier N3A is connected to the positive end of the first DC voltage via the resistor R27, and the non-inverting input end of the operational amplifier N3A is also connected to the first end of the adjustable resistor P8 via the resistor R28; The second end and the adjustable end of the adjustable resistor P8 are grounded, the output end of the operational amplifier N3A is connected to the inverting input end of the operational amplifier N3B via the resistor R26, the non-inverting input end of the operational amplifier N3B is grounded, the inverting input end of the operational amplifier N3B is also connected to the output end of the operational amplifier N3B via the resistor R58, the output end of the operational amplifier N3B is further connected to the first end of the resistor R25, and the second end of the resistor R25 is connected to the industrial personal computer as the output end of the valve feedback signal amplifying unit processing unit 18 .

The invention at least has the following beneficial effects: the device for testing steam turbine valve characteristics comprises a case, and a control card, an acquisition card, an acquisition interface and an industrial personal computer are arranged in the case; Relevant control instructions can be sent by the industrial personal computer, so that the control card controls the proportional valve to work; In the working process of the proportional valve, the acquisition card is used for acquiring a feedback signal, a control signal and an oil pressure signal; and finally, the industrial personal computer generates a corresponding characteristic curve according to the feedback signal, the control signal and the oil pressure signal, enabling personnel to comprehensively and intuitively monitor and diagnose faults in the proportional valve operation. The device can not only predict the fault in advance and prompt the fault personnel to take corresponding measures, but also replace the control system to control the proportional valve when the control system of the steam turbine valve is overhauled, thereby improving the reliability of the steam turbine valve system.

### BRIEF DESCRIPTION OF THE SEVERAL VIEWS OF THE DRAWINGS

The present invention will be further described with reference to the accompanying drawings and embodiments, in which:
FIG. 1 is a structural schematic diagram of a device for testing steam turbine valve characteristics provided by the present invention;
FIG. 2 is a structural schematic diagram of a case of the device for testing steam turbine valve characteristics provided by the present invention;
FIG. 3 is a structural schematic diagram of a control card of the device for testing steam turbine valve characteristics provided by the present invention;
FIG. 4 is a circuit diagram of a zero-point instruction signal processing unit provided by the present invention;
FIG. 5 is a circuit diagram of a feedforward input operation unit provided by the present invention;
FIG. 6 is a circuit diagram of a condition instruction signal setting unit provided by the present invention;
FIG. 7 is a circuit diagram of a coil current signal processing unit provided by the present invention;
FIG. 8 is a circuit diagram of the switching control unit of the coil current signal processing unit provided by the present invention;
FIG. 9 is a circuit diagram of an integrator output signal processing unit provided by the present invention;
FIG. 10 is a circuit diagram of a hydraulic servomotor feedback signal processing unit provided by the present invention;
FIG. 11 is a circuit diagram of the hydraulic servomotor feedback signal acquisition unit provided by the present invention;
FIG. 12 is a circuit diagram of the valve feedback signal processing unit provided by the present invention.

### DETAILED DESCRIPTION OF THE INVENTION

For a clearer understanding of the technical features, objects, and effects of the present invention, embodiments of the present invention will now be described in detail with reference to the accompanying drawings.

In a nuclear power plant, the steam turbine valve system includes a hydraulic servomotor for controlling the valve opening, a proportional valve for controlling the hydraulic servomotor, and a control system for controlling a proportional valve.

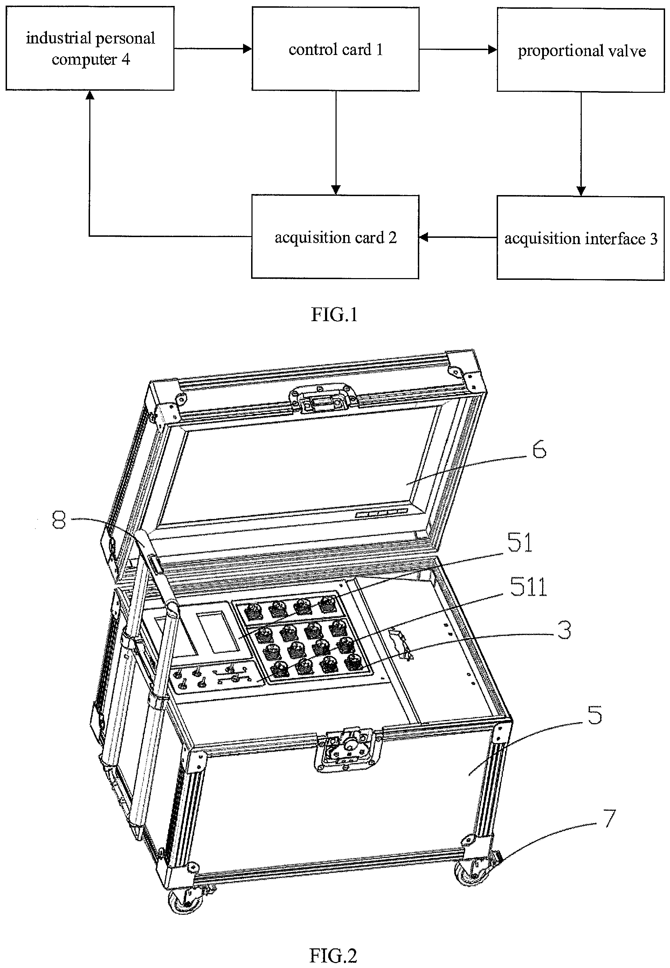

Referring to FIG. 1, the present invention constructs a device for testing steam turbine valve characteristics, which can replace the control system of the steam turbine valve to control the proportional valve, realize the control of the hydraulic servomotor, and realize the characteristic test of the proportional valve. And the device for testing steam turbine valve characteristics includes a case, and a control card 1, an acquisition card 2, an acquisition interface 3 and an industrial personal compute 4 are arranged in that case.

The control card 1 is used to control the operation of the proportional valve. Specifically, the control card 1 may generate a control instruction for controlling the proportional valve according to a control signal of the control system or the industrial personal computer 4 of the nuclear power plant and in combination with a feedback signal of the proportional valve; Wherein, the feedback signal includes at least one of a pilot valve feedback signal, a main valve feedback signal and a hydraulic servomotor feedback signal, and the control signal includes at least one of a coil current signal, a zero-point instruction signal, a condition instruction signal, a PID control signal and an integrator output signal.

The pilot valve feedback signal is used to reflect the pilot valve travel position information of the proportional valve, and that signal is sent to the control card 1 by the displacement sensor of the pilot valve.

The main valve feedback signal is used to reflect the main valve travel position information of the proportional valve, and that signal is sent to the control card 1 by the displacement sensor of the main valve.

The hydraulic servomotor feedback signal is used to reflect the travel position information of the hydraulic servomotor, and that signal is sent to the control card 1 by the displacement sensor of the hydraulic servomotor.

The coil current signal is used to drive the electromagnet of the pilot valve to control the pilot valve, thereby to control the opening and closing of the main valve, and that signal is sent to the electromagnet of the pilot valve by the control card 1.

The zero-point instruction signal is a signal for controlling the travel of the proportional valve, which is generated after the input signal of the control system or the industrial personal computer 4 is subjected to operation processing (such as PID operation).

The condition instruction signal is used to set the travel position of the main valve, and the signal controls the generation of the coil current signal by participating in the correlation operation processing together with the main valve feedback signal, so as to control the final travel position of the main valve. In addition, the operation of the signal is obtained by performing the correlation operation according to the zero-point instruction signal.

The PID control signal is the control signal output when the zero-point instruction signal participates in the PID operation, and the condition instruction signal can be obtained through the operation of the control signal.

The integrator output signal is the signal output after the integration operation of the zero- point instruction signal in the PID operation process.

The acquisition card 2 is connected to the control card 1 and is used for acquiring the feedback signal and the control signal of the control card 1, so that the industrial personal computer 4 can synchronously and accurately acquire the feedback signal and the control signal to accurately and truly reflect the working condition of the proportional valve, thereby improving the accuracy of the characteristic test. Wherein the feedback signal comprises at least one of a pilot valve feedback signal, a main valve feedback signal and a hydraulic servomotor feedback signal, and the control signal comprises at least one of a coil current signal, a zero-point instruction signal, a condition instruction signal, a PID control signal and an integrator output signal.

The acquisition interface 3 is connected to the acquisition card 2 and also connected to the pressure sensor of the hydraulic servomotor to send the oil pressure signal to the acquisition card 2.

In some embodiments, the oil pressure signal includes an oil pressure signal at a proportional valve inlet, an oil pressure signal after pressure reducing valve, an oil pressure signal at a pressure reducing valve A port, an oil pressure signal at a pressure reducing valve B port, and an oil pressure signal at a number of other locations (e.g., a PT4 oil pressure signal, a PT5 oil pressure signal, a PT7 oil pressure signal, etc.).

Further, the acquisition interface 3 includes several plugs, which are not only used to connect to the pressure sensor in the hydraulic servomotor, but also respectively connected to the displacement sensors in the hydraulic servomotor and the proportional valve, so as to receive the feedback signals from the main valve, the pilot valve and the hydraulic servomotor; these plugs also include four communication plugs.

The industrial personal computer 4 is connected to the control card 1 and the acquisition card 2, and is configured to control the control card 1 to work, and process the feedback signal, the control signal, and the oil pressure signal to generate a corresponding characteristic curve. Correspondingly, the corresponding characteristic curve comprises at least one of a pilot valve feedback signal characteristic curve, a main valve feedback signal characteristic curve, a hydraulic servomotor feedback signal characteristic curve, a coil current signal characteristic curve, a zero-point instruction signal characteristic curve, a condition instruction signal characteristic curve, a PID control signal characteristic curve and an integrator output signal characteristic curve; The operator can judge whether the proportional valve works normally by observing the characteristic curve.

In some embodiments, as shown in FIG. 2, the case is a clamshell case 5, an operation panel 51 for controlling the industrial personal computer 4 is further provided in the clamshell case 5, and the operation panel 51 can be operated by opening the clamshell of the clamshell case 5; The operation panel 51 is provided with a selection switch unit 511 for controlling the on-off of the feedback signal, realizing the enabling function and setting the working mode.

In some embodiments, the selection switch unit 511 includes a plurality of selection switches, wherein some of the selection switches are connected in series between each feedback signal and the control card 1, so as to simulate the case of feedback signal failure through the selection switches; At least one of the selection switches is connected to the enabling end of the controller output signal processing unit 17 of the control card 1 for controlling whether the controller output signal processing unit 17 is enabled, and some of the selection switches are connected to the industrial personal computer 4 for selecting the working mode of the characteristic test.

Further, the characteristic test includes four working modes, which are respectively: mode 1, simulating GRE001 test at a piecewise variable rate of 21%/s; mode 2, simulating GRE001 test at a constant closing rate of 1.1%/s; mode 3, simulating the GRE001 test at a closing rate of 8.9%/s above 40% valve position and a closing rate of 1.5%/s below 40% valve position; mode 4, simulating the GRE001 test at a constant closing rate of 3.3%/s. Wherein the process of the GRE001 test comprises the following steps of: controlling a proportional valve to control a regulating valve to be closed based on a set closing rate; when the regulating valve is completely closed, controlling a stop valve of the proportional valve to be closed; after the stop valve is completely closed, controlling the regulating valve to be opened to 20% based on a set opening rate; and then controlling the regulating valve to be closed based on the set closing rate, And then control the stop valve to be opened, and after the stop valve is completely opened, controlling the regulating valve to be open to a normal operation opening degree based on a set opening rate. During the GRE001 test, the industrial personal computer 4 generates a corresponding characteristic curve according to the relevant signals collected by the acquisition card 2.

In order to facilitate wiring, in some embodiments, the plug in the acquisition interface 3 may be provided on the operation panel 51, and the type of the interface may be an aviation plug.

In some embodiments, as shown in FIG. 2, the device for testing steam turbine valve characteristics further includes a touch screen 6 disposed inside the flip cover of the clamshell case 5, the touch screen 6 is connected to the industrial personal computer 4, and the touch screen 6 is used for displaying the characteristic curves of the feedback signal, the control signal and the oil pressure signal in real time and acquiring the control instruction.

In order to improve portability, in some embodiments, the bottom of the clamshell case 5 is provided with a universal wheel 7, one side of the clamshell case 5 is provided with a telescopic rod 8, and the outside of the clamshell case 5 is provided with a handle assembly (not shown).

In some embodiments, the device for testing steam turbine valve characteristics further includes a power supply unit arranged inside the operation panel 51, the power supply unit is used for supplying power to each unit in the device, and the power supply unit comprises a first DC voltage, a second DC voltage and a third DC voltage; The first DC voltage may be ± 10 V, the positive end of the first DC voltage may be 10 V, the negative end of the first DC voltage may be -10 V, the second DC voltage may be ± 15 V, and the third DC voltage may be 24 V.

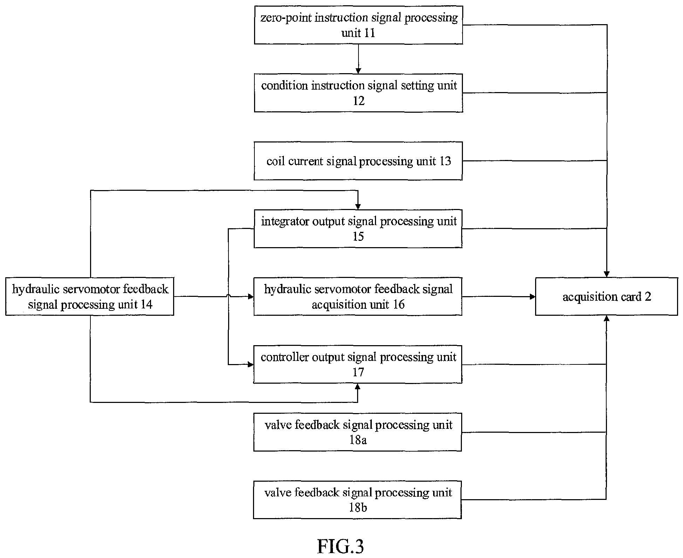

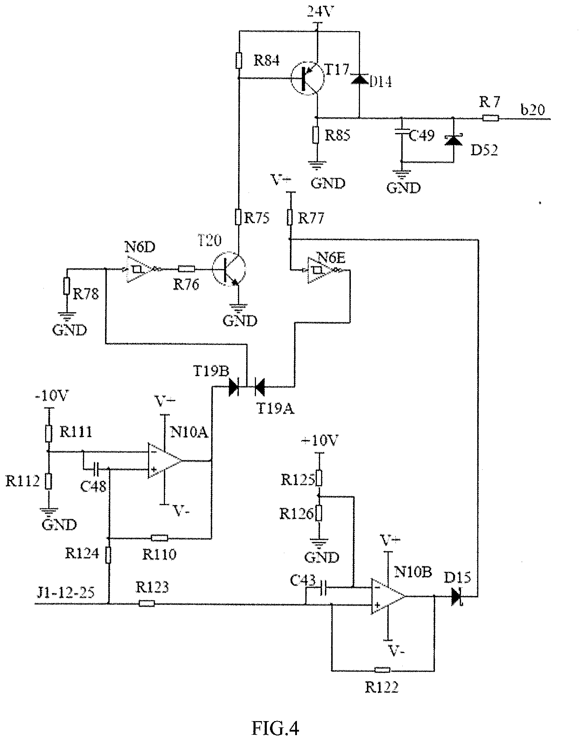

In some embodiments, as shown in FIG. 3, the control card 1 includes a zero-point instruction signal processing unit 11; Further, as shown in FIG.4, the zero-point instruction signal processing unit 11 includes a resistor R124, a resistor R123, an operational amplifier N10B, a capacitor C43, a resistor R126, a resistor R125, a resistor R122, a zener diode D15, a resistor R77, an inverter N6E, a diode T19A, an operational amplifier N10A, a capacitor C48, a resistor R111, a resistor R112, a resistor R110, a diode T19B, a resistor R78, an inverter N6D, a resistor R76, a NPN transistor T20, a resistor R75, a PNP transistor T17, a resistor R84, a diode D14, a resistor R85, a capacitor C49, a zener diode D52 and a resistor R7.

Specifically, the second end of the resistor R124 is used for receiving the zero-point control signal, the second end of the resistor R124 is also connected to the non-inverting input end of the operational amplifier N10B via resistor R123, the non-inverting input end of the operational amplifier N10B is connected to the inverting input end of the operational amplifier N10B via capacitor C43, the inverting input end of the operational amplifier N10B is connected to the ground via resistor R126, the inverting input end of the operational amplifier N10B is also connected to the positive end of a first DC voltage via resistor R125, the output end of the operational amplifier N10B is connected to the non-inverting input end of the operational amplifier N10B via resistor R122, the output end of the operational amplifier N10B is also connected to the anode of the zener diode D15, the cathode of the zener diode D15 is connected to a second DC voltage via resistor R77, the cathode of the zener diode D15 is also connected to the input end of the inverter N6E, and the output end of the inverter N6E is connected to the anode of the diode T19A.

The first end of the resistor R124 is connected to the non-inverting input end of the operational amplifier N10A, the non-inverting input end of the operational amplifier N10A is further connected to the inverting input end of the operational amplifier N10A via capacitor C48, the inverting input end of the operational amplifier N10A is connected to the negative end of a first DC voltage via resistor R111, the inverting input end of the operational amplifier N10A is also connected to the ground via resistor R112, the non-inverting input end of the operational amplifier N10A is connected to the output end of the operational amplifier N10A via resistor R110, and the output end of the operational amplifier N10A is connected to the anode of the diode T19B.

The cathode of the diode T19A is connected to the cathode of the diode T19B, the cathode of the diode T19B is connected to the ground via resistor R78, the cathode of the diode T19B is also connected to the input end of the inverter N6D, the output end of the inverter N6D is connected to the base of the NPN transistor T20 via resistor R76, the emitter of the NPN transistor T20 is grounded, the collector of the PNP transistor T20 is connected to the base of the PNP transistor T17 via resistor R75, the base of the PNP transistor T17 is connected to the third DC voltage via resistor R84, the collector of the PNP transistor T17 is connected to the ground via resistor R85, and the collector of the PNP transistor T17 is also connected to the anode of the diode D14. The cathode of the diode D14 and the emitter of the PNP transistor T17 are connected to a third DC voltage, the anode of the diode D14 is grounded via capacitor C49, the anode of the diode D14 is also connected to the cathode of the zener diode D52, the anode of the zener diode D52 is grounded, the anode of the diode D14 is also connected to the first end of the resistor R7, the second end of the resistor R7 is connected to the acquisition card 2 as a zero-point instruction signal output end, and the zero-point instruction signal output end is used for connecting a proportional valve.

To improve the sampling accuracy of the acquisition card 2, in some embodiments, the resistor R7 may be set to 100 ohms.

Referring to FIG. 4, the working principle of the zero-point instruction signal processing unit 11 is as follows: the zero-point control signal is input to the comparator composed of the operational amplifier N10B and the resistor R122 via resistor R123 in one branch, and in this branch, when the feedforward output signal is higher than voltage of the intersection point of the resistor R125 and the resistor R126, the operational amplifier N10B outputs a high level and passes through the inverter N6E, the signal will be inverted; The other branch of the feedforward output signal is input to a comparator composed of the operational amplifier N10B and the resistor R110 via resistor R124, and when the feedforward output signal is higher than voltage of the intersection point of the resistor R112 and the resistor R111, the operational amplifier N10A outputs a high level; The two output voltages of the two branch will affect the cathode voltage of the diode T19B. When the cathode voltage of the diode T19B is at a low level, the inverter N6D outputs a high level, so that the NPN transistor T20 is conducted, and then the PNP transistor T17 is also conducted. Finally, the zero-point instruction signal output end outputs a high level of a certain value under the action of the zener diode D52; Conversely, when the cathode voltage of the diode T19B is at a high level, the zero-point instruction signal output end outputs a low level.

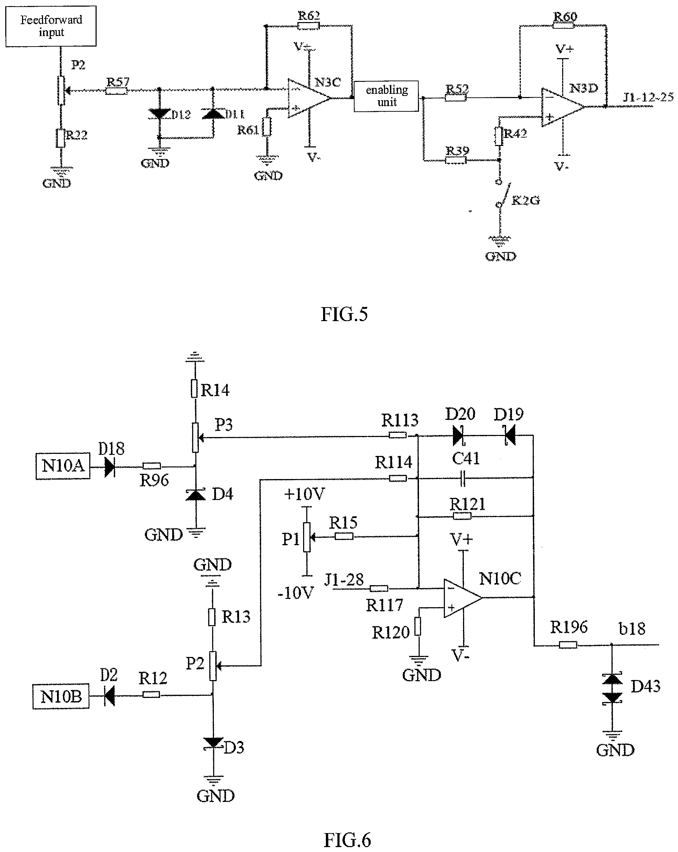

In some embodiments, as shown in FIG. 5, the control card 1 further includes a feedforward input operation unit, the input end of the feedforward input operation unit is used for receiving the feedforward output signal of the PID controller, and the output end of the feedforward input operation unit (corresponding to the output end of the operational amplifier N3D) is used for outputting the feedforward output signal to the zero-point instruction signal processing unit; In addition, the enabling unit in FIG. 5 can be regarded as a closed switch when enabled.

In some embodiments, as shown in FIGs. 3 and 6, the control card 1 further includes a condition instruction signal setting unit 12, which includes: a diode D18, a resistor R96, a zener diode D4, an adjustable resistor P3, a resistor R14, a resistor R113, a diode D2, a resistor R12, an adjustable resistor P2, a zener diode D3, a resistor R13, a resistor R114, a zener diode D20, a zener diode D19, a resistor R121, a resistor R15, an adjustable resistor P1, a resistor R117, an operational amplifier N10C, a resistor R120, a resistor R196 and a protection tube D43.

Specifically, the anode of the diode D18 is connected to the output end of the operational amplifier N10A, the cathode of the diode D18 is connected to the cathode of the zener diode D4 via resistor R96, the anode of the zener diode D4 is grounded, the cathode of the zener diode D4 is also connected to the second end of the adjustable resistor P3, the first end of the adjustable resistor P3 is connected to the ground via resistor R14, the adjustable end of the adjustable resistor P3 is connected to the first end of the resistor R113.

The cathode of the diode D2 is connected to the output end of the operational amplifier N10B, the anode of the diode D2 is connected to the second end of the adjustable resistor P2 via resistor R12, the second end of the adjustable resistor P2 is connected to the anode of the zener diode D3, the cathode of the zener diode D3 is grounded, the first end of the adjustable resistor P2 is connected to the ground via resistor R13, the adjustable end of the adjustable resistor P2 is connected to the first end of the resistor R114.

The second end of the resistor R114 is connected to the second end of the resistor R113 and the anode of the zener diode D20, the cathode of the zener diode D20 is connected to the cathode of the zener diode D19, the second end of the resistor R114 is connected to the anode of the zener diode D19 and the output end of the operational amplifier N10C via resistor R121, the second end of the resistor R114 is connected to the adjustable end of the adjustable resistor P1 via resistor R15, the first end of the adjustable resistor P1 is connected to the positive end of a first DC voltage, the second end of the adjustable resistor P1 is connected to the negative end of the first DC voltage, and the second end of the resistor R114 is also connected to the second end of the resistor R117 and the inverting input end of the operational amplifier N10C. The first end of the resistor R117 is connected to the industrial personal computer 4, the non-inverting input end of the operational amplifier N10C is connected to the ground via resistor 120, the output end of the operational amplifier N10C is connected to the first end of the resistor R196, the second end of the resistor R196 is connected to the ground via the protection tube D43, and the second end of the resistor R196, as the conditional instruction signal output end, is connected to the acquisition card 2.

Referring to FIG. 6, the operation principle of the condition instruction signal setting unit 12 is as follows. The operational amplifier N10C, the resistor R121, the resistor R117, and the resistor R120 constitute an amplifying circuit, the output voltage of the amplifying circuit is related to the resistance ratio of the resistor R121 and the resistor R117, the voltage at the first end of the resistor 117, and the voltage at the inverting input end of the operational amplifier N10C; The voltage of the inverting input end of the operational amplifier N10C is related to the adjustable resistor P1, the adjustable resistor P2, the adjustable resistor P3, the output voltage of the operational amplifier N10A (the high level of the output of the operational amplifier N10A will affect the output voltage of the voltage dividing circuit composed of the resistor R96, the adjustable resistor P3 and the resistor R14 at the adjustable end of the adjustable resistor P3) and the output voltage of the operational amplifier N10B (the high level of the output of the operational amplifier N10B will affect the output voltage of the voltage dividing circuit composed of the resistor R12, the adjustable resistor P2 and the resistor R13 at the adjustable end of the adjustable resistor P2). Therefore, in this embodiment, the voltage at the output end of the operational amplifier N10C can be controlled by adjusting the adjustable resistor P1, the adjustable resistor P2, the adjustable resistor P3, and the voltage at the first end of the resistor 117. In addition, the output end of the operational amplifier N10C is also connected to a related operational circuit (not shown, mainly used to participate in the generation and operation of the coil current signal).

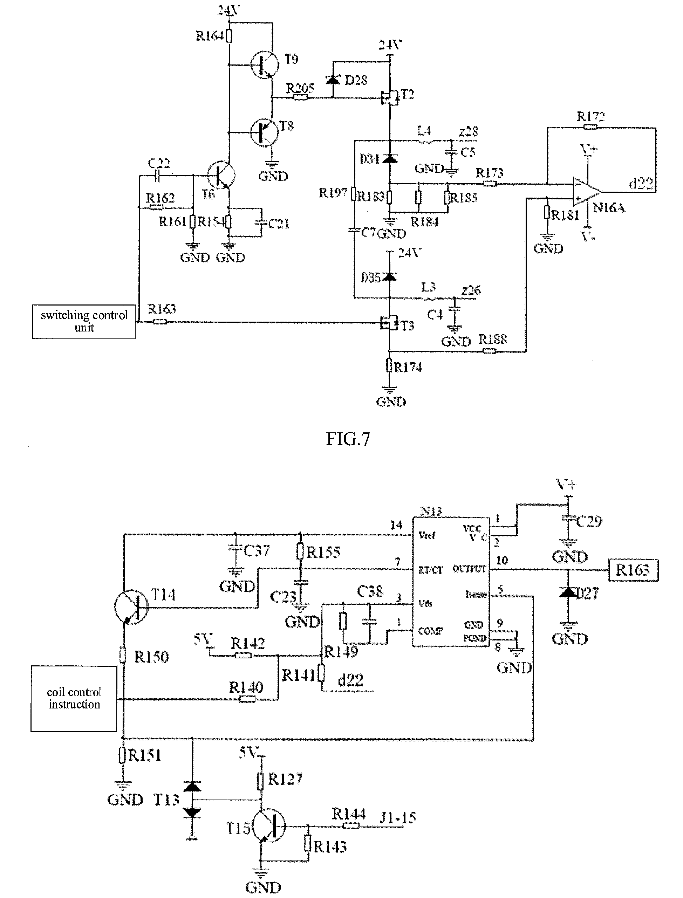

In some embodiments, as shown in FIGs. 3 and 7, the control card 1 further include a coil current signal processing unit 13, Which includes a switching control unit, a resistor R162, an NPN transistor T6, a resistor R161, a resistor R154, a resistor R164, a PNP transistor T8, an NPN transistor T9, a resistor R205, a zener diode D28, a PMOS transistor T2, an inductor L4, a diode D34, a capacitor C5, a resistor R173, an operational amplifier N16A, a resistor R183, a resistor R172, a resistor R181, a resistor R188, an NMOS transistor T3, a resistor R163, a resistor R174, a diode D35, an inductor L3 and a capacitor C4.

Specifically, the switching signal output end of the switching control unit is connected to the base of the NPN transistor T6 via resistor R162, the base of the NPN transistor T6 is also connected to the ground via resistor R161, the emitter of the NPN transistor T6 is connected to the ground via resistor R154, the collector of the NPN transistor T6 is connected to a third DC voltage via resistor R164, the collector of the NPN transistor T6 is also connected to the base of the PNP transistor T8 and the base of the NPN transistor T9, the collector of the NPN transistor T9 is connected to a third DC voltage, the emitter of the NPN transistor T9 is connected to the emitter of the PNP transistor T8, the collector of the PNP transistor T8 is grounded, the emitter of the PNP transistor T8 is also connected to the anode of the zener diode D28 via resistor R205, the anode of the zener diode D28 is connected to the gate of the PMOS transistor T2, the cathode of the zener diode D28 and the source of the PMOS transistor T2 are connected to a third DC voltage, the drain of the PMOS transistor T2 is connected to the first end of the inductor L4 and the cathode of the diode D34, the second end of the inductor L4 is connected to the ground via capacitor C5, the second end of the inductor L4 is a first coil current signal output end and can be connected to the electromagnet coil of the pilot valve.

The anode of diode D34 is connected to the inverting input of operational amplifier N16A via resistor R173, the anode of diode D34 is also connected to ground via resistor R183, the inverting input of operational amplifier N16A is connected to the output of operational amplifier N16A via resistor R172, the output end of the operational amplifier N16A serves as an error signal sampling end and is connected to the acquisition card 2, the non-inverting input end of the operational amplifier N16A is connected to the ground via resistor R181, the non-inverting input end of the operational amplifier N16A is also connected to the source electrode of the NMOS transistor T3 via resistor R188, the source electrode of the NMOS transistor T3 is connected to the ground via resistor R174, The gate of the NMOS transistor T3 is connected to the switching signal output end of the switching control unit via resistor R163, the drain of the NMOS transistor T3 is connected to the anode of the diode D35, the cathode of the diode D35 is connected to a third DC voltage, the drain of the NMOS transistor T3 is also connected to the first end of the inductor L3, the second end of the inductor L3 is connected to the ground via capacitor C4, the second end of the inductor L3 is a second coil current signal output end and can be connected to the electromagnet coil of the pilot valve.

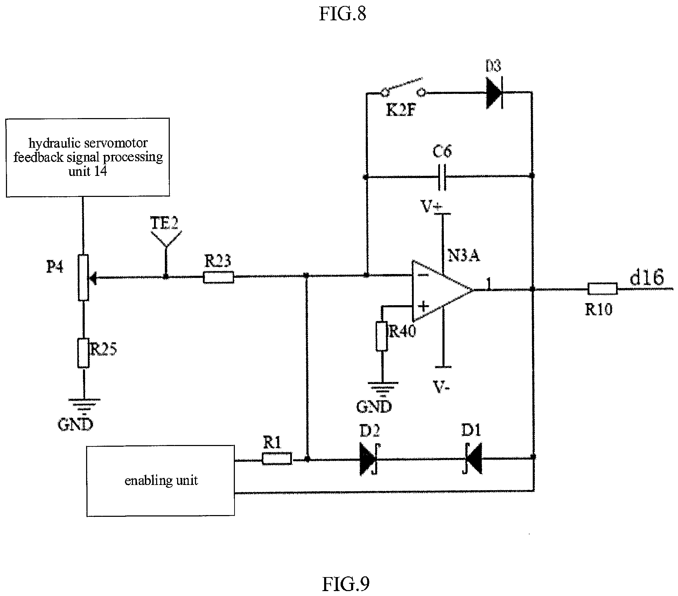

In some embodiments, the circuit diagram of the switching control unit may refer to FIG. 8, wherein the coil control instruction is obtained by performing correlation operation on a valve feedback signal (including a pilot valve feedback signal and a main valve feedback signal) and a condition instruction signal. And the 10th pin of the switching power supply chip N13 is the switching signal output end of the switching control unit.

Referring to FIG. 7, the working principle of the coil current signal processing unit 13 is as follows: when the switching signal output by the switching control unit is at a high level, one path of the switching signal is input to the base of the NPN transistor T6 via resistor 162, so that the NPN transistor T6 is conducted, then the PNP transistor T8 and the NPN transistor T9 are also conducted, and then the PMOS transistor T2 is also conducted; The other path of the switching signal is input to the gate of the NMOS transistor T3 via resistor 163, so that the NMOS transistor T3 is conducted, and finally the third DC voltage passes through the PMOS transistor T2, the inductor L4, the electromagnet coil of the pilot valve, the inductor L3, the NMOS transistor T3 and the resistor R174 to form a loop, so that the electromagnet coil of the pilot valve is excited, and the pilot valve starts to operate.

In some embodiments, as shown in FIG. 3, the control card 1 further includes a hydraulic servomotor feedback signal processing unit 14 and an integrator output signal processing unit 15; The hydraulic servomotor feedback signal processing unit 14 is used for acquiring voltage and current signals fed back by the proportional valve, and processing the voltage and current signals to obtain current and voltage feedback signals.

In some embodiments, as shown in FIG. 9, the integrator output signal processing unit 15 includes an adjustable resistor P4, a resistor R25, a resistor R23, an operational amplifier N3A, a resistor R1, a resistor R40, a zener diode D2, a zener diode D1, a capacitor C6, a selection switch K2F, a diode D3, and a resistor R10.

Specifically, the first end of the adjustable resistor P4 is connected to the hydraulic servomotor feedback signal processing unit 14 to receive the current and voltage feedback signals, the second end of the adjustable resistor P4 is connected to the ground via resistor R25, the adjustable end of the adjustable resistor P4 is connected to the inverting input end of the operational amplifier N3A via resistor R23. The inverting input end of the operational amplifier N3A is connected to the second end of the resistor R1, the second end of the resistor R1 is used for being connected to the enabling unit of the control card 1, the non-inverting input end of the operational amplifier N3A is connected to the ground via resistor R40, the inverting input end of the operational amplifier N3A is also connected to the anode of the zener diode D2, the cathode of the zener diode D2 is connected to the cathode of the zener diode D1. The anode of the zener diode D1 is connected to the output end of an operational amplifier N3A, the anode of the zener diode D1 is used for being connected to an enabling unit, the inverting input end of the operational amplifier N3A is connected to the output end of the operational amplifier N3A via capacitor C6, the inverting input end of the operational amplifier N3A is also connected to the anode of a diode D3 via selection switch K2F. The cathode of the diode D3 is connected to the output end of the operational amplifier N3A, the output end of the operational amplifier N3A is connected to the first end of the resistor R10, and the second end of the resistor R10 is connected to the acquisition card 2 as the integrator output signal output end. When the enabling unit performs an enabling operation, it is equivalent that the second end of the resistor R1 is short-circuited with the output end of the operational amplifier N3A.

For improving the sampling accuracy of the acquisition card 2, in some embodiments, the resistor R10 may be set to 100 ohms.

Referring to FIG. 9, the working principle of the integrator output signal processing unit 15 is as follows: after being divided by the adjustable resistor P4 and the resistor R25, the current and voltage feedback signals are input to the inverting input end of the operational amplifier N3A via resistor R23. When the enabling unit acts, the operational amplifier N3A, the resistor R1 and the resistor R23 form an amplifying circuit. The divided current and voltage feedback signals are amplified, and finally the amplified signals are output from the output end of the operational amplifier N3A, participate in PID operation (not shown), and are input to the acquisition card 2 via resistor R10.

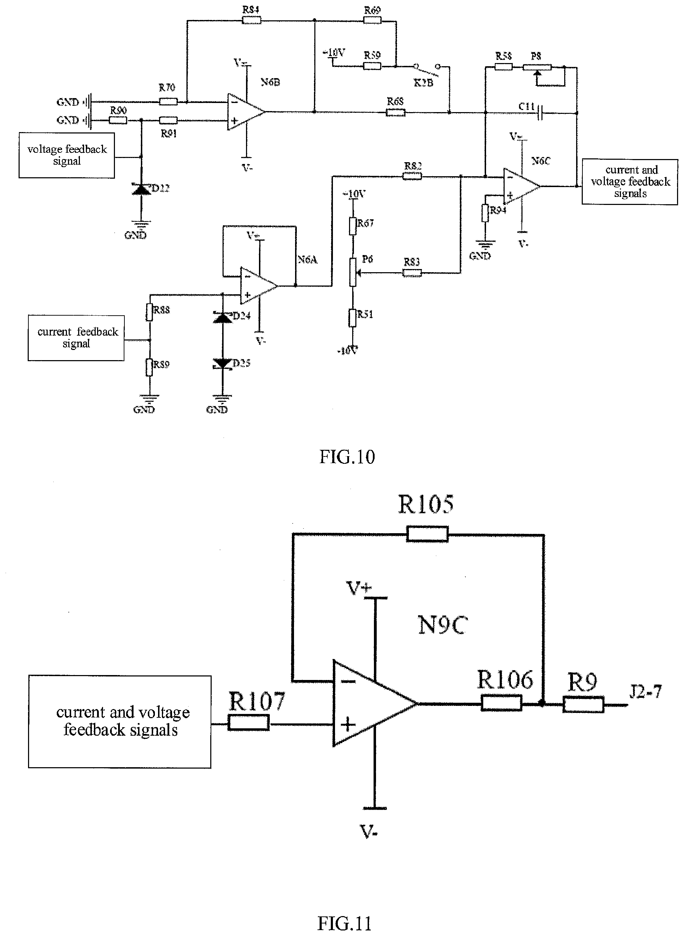

In some embodiments, the circuit diagram of the hydraulic servomotor feedback signal processing unit 14 can refer to FIG. 10, wherein the voltage feedback signal and the current feedback signal are respectively from the voltage feedback signal and the current feedback signal output by the valve displacement sensor of the hydraulic servomotor.

In some embodiments, as shown in FIG. 3, the control card 1 further includes a hydraulic servomotor feedback signal acquisition unit 16 and/or a controller output signal processing unit 17.

Specifically, the hydraulic servomotor feedback signal acquisition unit 16 is connected to the hydraulic servomotor feedback signal processing unit 14 and the acquisition card 2 to filter the current and voltage feedback signals and send the filtered signals to the acquisition card 2. The controller output signal processing unit 17 is connected to the integrator output signal processing unit 15 and the hydraulic servomotor feedback signal processing unit 14 to perform calculation according to the integrator output signal output by the integrator output signal processing unit 15 and the current and voltage feedback signals to obtain a PID control output signal and send the PID control output signal to the acquisition card 2. In addition, the controller output signal processing unit 17 and the integrator output signal processing unit 15 together form a PID operation circuit, and the PID control output signal is finally operated with the feedforward output signal to obtain a zero-point control signal, which further participates in the operation of the zero-point instruction signal.

In some embodiments, the circuit diagram of the hydraulic servomotor feedback signal acquisition unit 16 can refer to FIG. 11.

In some embodiments, as shown in FIG. 3, the control card 1 further includes two valve feedback signal processing units 18; specifically, the input end of a valve feedback signal processing unit 18a is connected to the acquisition card 2 and can be connected to a pilot valve feedback signal output end of the proportional valve, and the output end of the valve feedback signal processing unit 18a is connected to the industrial personal computer 4. The input end of the other valve feedback signal processing unit 18b is connected to the acquisition card 2 and can be connected to the main valve feedback signal output end of the proportional valve, and the output end of the other valve feedback signal processing unit 18b is connected to the industrial personal computer 4.

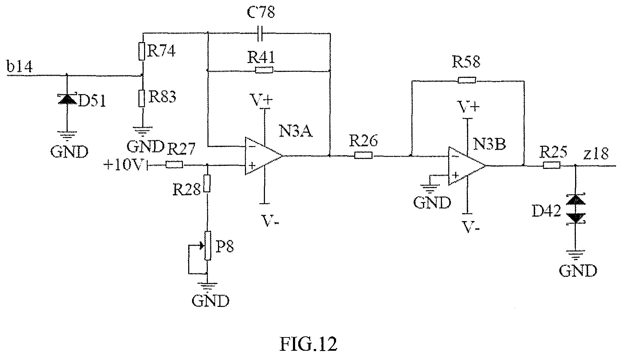

In some embodiments, as shown in FIG.12. Each valve feedback signal processing unit 18 includes a zener diode D51, a resistor R74, an operational amplifier N3A, a resistor R83, a resistor R41, a resistor R27, a resistor R28, an adjustable resistor P8, a resistor R26, an operational amplifier N3B, a resistor R58, a resistor R25, and a protection diode D42.

Specifically, the cathode of the zener diode D51 is the input end of the valve feedback signal processing unit 18, the cathode of the zener diode D51 is connected to the inverting input end of the operational amplifier N3A via resistor R74, the cathode of the zener diode D51 is also connected to the ground via resistor R83, the anode of the zener diode D51 is grounded. The inverting input end of the operational amplifier N3A is connected to the output end of the operational amplifier N3A via resistor R41, the non-inverting input end of the operational amplifier N3A is connected to the positive end of a first DC voltage via resistor R27, the non-inverting input end of the operational amplifier N3A is also connected to the first end of the adjustable resistor P8 via resistor R28, the second end and the adjustable end of the adjustable resistor P8 are grounded. The output end of the operational amplifier N3A is connected to the inverting input end of the operational amplifier N3B via resistor R26, the non-inverting input end of the operational amplifier N3B is grounded, the inverting input end of the operational amplifier N3B is also connected to the output end of the operational amplifier N3B via resistor R58, the output end of the operational amplifier N3B is also connected to the first end of the resistor R25, the second end of the resistor R25 is connected to the industrial personal computer 4 as the output end of the valve feedback signal processing unit 18.

Referring to FIG. 12, the working principle of the valve feedback signal processing unit 18 is as follows: the input end of the valve feedback signal processing unit 18 is used for receiving the signal output by the displacement sensor of the main valve or the pilot valve. The resistor R74, the operational amplifier N3A, the resistor R83, the resistor R41, the resistor R27, the resistor R28 and the adjustable resistor P8 form a primary amplifying circuit, the amplifying circuit amplifies the output signal of the displacement sensor, the amplified signal is input to the inverting input end of the operational amplifier N3B via the resistor R26. The operational amplifier N3B, the resistor R26 and the resistor R58 form a second-stage amplifying circuit to amplify the signal again, and the output end of the operational amplifier N3B outputs the final valve feedback signal to the industrial personal computer 4 via resistor 25, and at the same time, the valve feedback signal and the condition instruction signal participate in the operation of the coil control instruction (not shown).

The invention at least has the following advantages: the device for testing steam turbine valve characteristics includes a case, wherein a control card, an acquisition card, an acquisition interface and an industrial personal computer are arranged in the case; a relevant control instruction can be sent by the industrial personal computer, so that the control card controls the proportional valve to work; in the working process of the proportional valve, the acquisition card is used for acquiring a feedback signal, a control signal and an oil pressure signal; and finally, the industrial personal computer issues a corresponding characteristic curve according to the feedback signal, the control signal and the oil pressure signal. The device can not only predict the fault in advance and prompt the fault personnel to take corresponding measures, but also replace the control system to control the proportional valve when the control system of the steam turbine valve is overhauled, thereby improving the reliability of the steam turbine valve system.

It can be understood that the above embodiments only represent the preferred embodiments of the present invention, and the description is more specific and detailed, but it can not be understood as the limitation of the patent scope of the present invention; It should be noted that, for those of ordinary skill in the art, the above technical features can be freely combined, and several modifications and improvements can be made without departing from the concept of the present invention, which all fall within the scope of protection of the present invention; Accordingly, it is intended that all changes and modifications which come within the scope of the appended claims shall be construed accordingly.

## Claims

1. A device for testing steam turbine valve characteristics, wherein the device comprise a case, and a control card (1), an acquisition card (2), an acquisition interface (3) and an industrial personal computer (4) are arranged in the case;
the control card (1) is used for controlling a proportional valve to work;
the acquisition card (2) is connected to the control card (1) and is used for acquiring a feedback signal and a control signal of the control card (1); wherein the feedback signal comprises at least one of a pilot valve feedback signal, a main valve feedback signal and a hydraulic servomotor feedback signal, and the control signal comprises at least one of a coil current signal, a zero-point instruction signal, a condition instruction signal, a PID control signal and an integrator output signal;
the acquisition interface (3) is connected to the acquisition card (2) and is also connected to a pressure sensor in the hydraulic servomotor to send an oil pressure signal to the acquisition card (2);
the industrial personal computer (4) is connected to the control card (1) and the acquisition card (2) and is used for controlling the control card (1) to work and processing the feedback signal, the control signal and the oil pressure signal to generate a corresponding characteristic curve.

2. The device for testing steam turbine valve characteristics according to claim 1, wherein the case is a clamshell case (5), and an operation panel (51) for controlling the industrial personal computer (4) is further arranged in the clamshell case (5);
and the operation panel (51) is provide with a selection switch unit (511) used for controlling the on-off of the feedback signal, realizing the enabling function and setting the work mode.

3. The device for testing steam turbine valve characteristics according to claim 2, further comprising a touch screen (6) arranged on the inner side of the flip cover of the clamshell case (5), wherein the touch screen (6) is connected to the industrial personal computer (4), and the touch screen (6) is used for displaying characteristic curves of the feedback signal, the control signal and the oil pressure signal in real time; and acquirring a control instruction.

4. The device for testing steam turbine valve characteristics according to claim 1, wherein the control card (1) comprises a zero-point instruction signal processing unit (11); which comprises a resistor R124, a resistor R123, an operational amplifier N10B, a resistor R126, a resistor R125, a resistor R122, a zener diode D15, a resistor R77, an inverter N6E, a diode T19A, an operational amplifier N10A, a resistor R111, a resistor R112, a resistor R110, a diode T19B, a resistor R78, an inverter N6D, a resistor R76, an NPN transistor T20, a resistor R75, a PNP transistor T17, a resistor R84, a diode D14, a resistor R85, a zener diode D52 and a resistor R7;
the second end of the resistor R124 is used for receiving a zero-point control signal, the second end of the resistor R124 is further connected to the non-inverting input end of the operational amplifier N10B via the resistor R123, and the inverting input end of the operational amplifier N10B is connected to the ground via the resistor R126; the inverting input end of the operational amplifier N10B is also connected to the positive end of a first DC voltage via the resistor R125, the output end of the operational amplifier N10B is connected to the non-inverting input end of the operational amplifier N10B via the resistor R122, and the output end of the operational amplifier N10B is also connected to the anode of the zener diode D15; the cathode of the zener diode D15 is connected to a second DC voltage via the resistor R77, the cathode of the zener diode D15 is also connected to the input end of the inverter N6E, and the output end of the inverter N6E is connected to the anode of the diode T19A;
the first end of the resistor R124 is connected to the non-inverting input end of the operational amplifier N10A, the inverting input end of the operational amplifier N10A is connected to the negative end of a first DC voltage via the resistor R111, and the inverting input end of the operational amplifier N10A is connected to the ground via the resistor R112; the non-inverting input end of the operational amplifier N10A is connected to the output end of the operational amplifier N10A via the resistor R110, and the output end of the operational amplifier N10A is connected to the anode of the diode T19B;
the cathode of the diode T19A is connected to the cathode of the diode T19B, the cathode of the diode T19B is connected to the ground via resistor R78, the cathode of the diode T19B is further connected to the input end of the inverter N6D, the output end of the inverter N6D is connected to the base of the NPN transistor T20 via the resistor R76, the emitter of the PNP transistor T20 is grounded, the collector of the PNP transistor T20 is connected to the base of the PNP transistor T17 via the resistor R75, the base of the PNP transistor T17 is connected to a third DC voltage via the resistor R84, and the collector of the PNP transistor T17 is connected to the ground via the resistor R85; the collector of the PNP transistor T17 is further connected to the anode of the diode D14, the cathode of the diode D14 and the emitter of the PNP transistor T17 are connected to a third DC voltage, the anode of the diode D14 is further connected to the cathode of the zener diode D52, and the anode of the zener diode D52 is grounded; the anode of the diode D14 is also connected to the first end of the resistor R7, the second end of the resistor R7 is connected to the acquisition card (2) as a zero-point instruction signal output end, and the zero-point instruction signal output end is used for connecting the proportional valve.

5. The device for testing steam turbine valve characteristics according to claim 4, wherein the control card (1) further comprises a condition instruction signal setting unit (12); which comprises a diode D18, a resistor R96, a zener diode D4, an adjustable resistor P3, a resistor R14, a resistor R113, a diode D2, a resistor R12, an adjustable resistor P2, a zener diode D3, a resistor R13, a resistor R114, a zener diode D20, a zener diode D19, a resistor R121, a resistor R15, an adjustable resistor P1, a resistor R117, an operational amplifier N10C, a resistor R120, a resistor R196 and a protection tube D43;
the anode of the diode D18 is connected to the output end of the operational amplifier N10A, the cathode of the diode D18 is connected to the cathode of the zener diode D4 via the resistor R96, the anode of the zener diode D4 is grounded, and the cathode of the zener diode D4 is also connected to the second end of the adjustable resistor P3; the first end of the adjustable resistor P3 is connected to the ground via the resistor R14, and the adjustable end of the adjustable resistor P3 is connected to the first end of the resistor R113;
the cathode of the diode D2 is connected to the output end of the operational amplifier N10B, the anode of the diode D2 is connected to the second end of the adjustable resistor P2 via the resistor R12, the second end of the adjustable resistor P2 is also connected to the anode of the zener diode D3, and the cathode of the zener diode D3 is grounded; the first end of the adjustable resistor P2 is connected to the ground via the resistor R13, and the adjustable end of the adjustable resistor P2 is connected to the first end of the resistor R114;
the second end of the resistor R114 is connected to the second end of the resistor R113 and the anode of the zener diode D20, the cathode of the zener diode D20 is connected to the cathode of the zener diode D19, and the second end of the resistor R114 is also connected to the anode of the zener diode D19 and the output end of the operational amplifier N10C via the resistor R121; the second end of the resistor R114 is also connected to the adjustable end of the adjustable resistor P1 via the resistor R15, the first end of the adjustable resistor P1 is connected to the positive end of a first DC voltage, and the second end of the resistor R114 is further connected to the second end of the resistor R117 and the inverting input end of the operational amplifier N10C; the first end of the resistor R117 is connected to the industrial personal computer (4), the non-inverting input end of the operational amplifier N10C is connected to the ground via the resistor 120, the output end of the operational amplifier N10C is connected to the first end of the resistor R196, the second end of the resistor R196 is connected to the ground via the protection tube D43, the second end of the resistor R196 is connected to the acquisition card (2) as a conditional instruction signal output end.

6. The device for testing steam turbine valve characteristics according to claim 3, wherein the control card (1) further comprises a coil current signal processing unit (13), which comprises a switching control unit, a resistor R162, an NPN transistor T6, a resistor R161, a resistor R154, a resistor R164, a PNP transistor T8, an NPN transistor T9, a resistor R205, a zener diode D28, a PMOS transistor T2, an inductor L4, a diode D34, a capacitor C5, a resistor R173, an operational amplifier N16A, a resistor R183, a resistor R172, a resistor R181, a resistor R188, an NMOS transistor T3, a resistor R163, a resistor R174, a diode D35 and a inductor L3;
the switching signal output end of the switching control unit is connected to the base of the NPN transistor T6 via the resistor R162, the base of the NPN transistor T6 is also connected to the ground via the resistor R161, the emitter of the NPN transistor T6 is connected to the ground via the resistor R154, the collector of the NPN transistor T6 is connected to a third DC voltage via the resistor R164, the collector of the NPN transistor T6 is also connected to the base of the PNP transistor T8 and the base of the NPN transistor T9, the collector of the NPN transistor T9 is connected to a third DC voltage, and the emitter of the NPN transistor T9 is connected to the emitter of the PNP transistor T8; the collector of the PNP transistor T8 is grounded, the emitter of the PNP transistor T8 is also connected to the anode of the zener diode D28 via the resistor R205, the anode of the zener diode D28 is connected to the gate of the PMOS transistor T2, and the cathode of the zener diode D28 and the source of the PMOS transistor T2 are connected to a third DC voltage; the drain of the PMOS transistor T2 is connected to the first end of the inductor L4 and the cathode of the diode D34, the second end of the inductor L4 is connected to the ground via the capacitor C5, and the second end of the inductor L4 is a first coil current signal output end that can be connected to the electromagnet coil of the pilot valve;
the anode of the diode D34 is connected to the inverting input end of the operational amplifier N16A via the resistor R173, the anode of the diode D34 is also connected to the ground via the resistor R183, the inverting input end of the operational amplifier N16A is connected to the output end of the operational amplifier N16A via the resistor R172, the output end of the operational amplifier N16A is connected to the acquisition card (2) as an error signal sampling end, the non-inverting input end of the operational amplifier N16A is connected to the ground via the resistor R181, and the non-inverting input end of the operational amplifier N16A is also connected to the source of the NMOS transistor T3 via the resistor R188, the source of the NMOS transistor T3 is connected to the ground via the resistor R174, the gate of the NMOS transistor T3 is connected to the switching signal output end of the switching control unit via the resistor R163, the drain of the NMOS transistor T3 is connected to the anode of the diode D35, and the cathode of the diode D35 is connected to the third DC voltage, the drain of the NMOS transistor T3 is also connected to the first end of the inductor L3, and the second end of the inductor L3 is a second coil current signal output end which can be connected to the electromagnet coil of the pilot valve.

7. The device for testing steam turbine valve characteristics according to claim 1 or 6, wherein the control card (1) further comprises a hydraulic servomotor feedback signal processing unit (14) and an integrator output signal processing unit (15);
the hydraulic servomotor feedback signal processing unit (14) is used for collecting voltage and current signals fed back by the proportional valve and processing the voltage and current signals to obtain current and voltage feedback signals;
wherein, the integrator output signal processing unit (15) comprises an adjustable resistor P4, a resistor R25, a resistor R23, an operational amplifier N3A, a resistor R1, a resistor R40, a zener diode D2, a zener diode D1, a capacitor C6, a selection switch K2F, a diode D3 and a resistor R10;
the first end of the adjustable resistor P4 is connected to the hydraulic servomotor feedback signal processing unit (14) for receiving the current and voltage feedback signals, the second end of the adjustable resistor P4 is connected to the ground via the resistor R25, and the adjustable end of the adjustable resistor P4 is connected to the inverting input end of the operational amplifier N3A via the resistor R23; the inverting input end of the operational amplifier N3A is connected to the second end of the resistor R1, the second end of the resistor R1 is connected to the enabling unit of the control card (1), the non-inverting input end of the operational amplifier N3A is connected to the ground via the resistor R40, and the inverting input end of the operational amplifier N3A is also connected to the anode of the zener diode D2; the cathode of the zener diode D2 is connected to the cathode of the zener diode D1, the anode of the zener diode D1 is connected to the output end of the operational amplifier N3A, the anode of the zener diode D1 is connected to the enabling unit, the inverting input end of the operational amplifier N3A is connected to the output end of the operational amplifier N3A via the capacitor C6, the inverting input end of the operational amplifier N3A is also connected to the anode of the diode D3 via the selection switch K2F, the cathode of the diode D3 is connected to the output end of the operational amplifier N3A, the output end of the operational amplifier N3A is connected to the first end of the resistor R10, the second end of the resistor R10 is connected to the acquisition card (2) as an integrator output signal output end.

8. The device for testing steam turbine valve characteristics according to claim 7, wherein the control card (1) further comprises a hydraulic servomotor feedback signal acquisition unit (16) and/or a controller output signal processing unit (17);
the hydraulic servomotor feedback signal acquisition unit (16) is connected to the hydraulic servomotor feedback signal processing unit (14) and the acquisition card (2) for filtering the current and voltage feedback signals and then send the filtered signals to the acquisition card (2);
the controller output signal processing unit (17) is connected to the integrator output signal processing unit (15) and the hydraulic servomotor feedback signal processing unit (14) to perform operation according to the integrator output signal output by the integrator output signal processing unit (15), and the current and voltage feedback signals to obtain a PID control output signal, and send the PID control output signal to the acquisition card (2).

9. The device for testing steam turbine valve characteristics according to claim 7, wherein the control card (1) further comprises two valve feedback signal processing units (18);
the input end of one valve feedback signal processing unit (18) is connected to the acquisition card (2) and can be connected to the pilot valve feedback signal output end of the proportional valve, and the output end of the valve feedback signal processing unit (18) is connected to the industrial personal computer (4);
the input end of the other valve feedback signal processing unit (18) is connected to the acquisition card (2) and can be connected to the main valve feedback signal output end of the proportional valve, and the output end of the other valve feedback signal processing unit (18) is connected to the industrial personal computer (4).

10. The device for testing steam turbine valve characteristics according to claim 9, wherein each valve feedback signal processing unit (18) comprises a zener diode D51, a resistor R74, an operational amplifier N3A, a resistor R83, a resistor R41, a resistor R27, a resistor R28, an adjustable resistor P8, a resistor R26, an operational amplifier N3B, a resistor R58, a resistor R25 and a protection tube D42;
the cathode of the zener diode D51 is the input end of the valve feedback signal processing unit (18), the cathode of the zener diode D51 is connected to the inverting input end of the operational amplifier N3A via the resistor R74, the cathode of the zener diode D51 is also connected to the ground via the resistor R83, and the anode of the zener diode D51 is grounded; the inverting input end of the operational amplifier N3A is connected to the output end of the operational amplifier N3A via the resistor R41, the non-inverting input end of the operational amplifier N3A is connected to the positive end of a first DC voltage via the resistor R27, and the non-inverting input end of the operational amplifier N3A is also connected to the first end of the adjustable resistor P8 via the resistor R28; the second end and the adjustable end of the adjustable resistor P8 are grounded, the output end of the operational amplifier N3A is connected to the inverting input end of the operational amplifier N3B via the resistor R26, the non-inverting input end of the operational amplifier N3B is grounded, the inverting input end of the operational amplifier N3B is also connected to the output end of the operational amplifier N3B via the resistor R58, the output end of the operational amplifier N3B is further connected to the first end of the resistor R25, and the second end of the resistor R25 is connected to the industrial personal computer (4) as the output end of the valve feedback signal processing unit (18).
